# EUROPEAN PATENT APPLICATION

(11) **EP 4 793 991 A1**
(43) Date of publication of application: **19.08.2026**
(21) Application number: 24881166.3
(22) Date of filing: 07.08.2024
(51) Int. Cl.: H01L 21/56, H01L 23/498

(54) **RADIO FREQUENCY POWER MODULE AND ELECTRONIC DEVICE**

(30) Priority: 27.10.2023 CN 202311414905
(71) Applicant: HUAWEI TECHNOLOGIES CO., LTD., Shenzhen 518129 (CN)
(72) Inventor: LIN, Yanhai, Shenzhen, Guangdong 518129 (CN); HUANG, Shujun, Shenzhen, Guangdong 518129 (CN); LI, Yijie, Shenzhen, Guangdong 518129 (CN); WANG, Rui, Shenzhen, Guangdong 518129 (CN)
(74) Representative: Maiwald GmbH
(86) International application number: PCT/CN2024/110355
(87) International publication number: WO 2025/086797

(57) **Abstract**

Embodiments of this application, relating to the field of communication device technologies, provide a radio frequency power assembly and an electronic device. The radio frequency power assembly includes a substrate, a first chip, a second chip, an insulation layer, at least three conductive blocks, a first connection part, and a second connection part. The insulation layer is at least partially disposed on a side that is of the first chip and the second chip and that is away from the substrate. The at least three conductive blocks are disposed on a side that is of the insulation layer and that is away from the substrate, where the at least three conductive blocks are spaced and arranged in a second direction. One end of the first connection part penetrates the insulation layer and is connected to the first chip, and the other end is connected to one end of a conductive block; and one end of the second connection part penetrates the insulation layer and is electrically connected to the second chip, and the other end is electrically connected to the other end of the conductive block. Areas of surfaces that are of at least two of the three conductive blocks and that are away from the substrate are different. A structure design of the radio frequency power assembly avoids use of a structure of a three-dimensional binding wire group, thereby effectively reducing complexity of preparing the radio frequency power assembly.

## Description

This application claims priority to Chinese Patent Application No. 202311414905.9, filed with the China National Intellectual Property Administration on October 27, 2023 and entitled "RADIO FREQUENCY POWER ASSEMBLY AND ELECTRONIC DEVICE", which is incorporated herein by reference in its entirety.

### TECHNICAL FIELD

This application relates to the field of communication device technologies, and in particular, to a radio frequency power assembly and an electronic device.

### BACKGROUND

A power amplifier (Power Amplifier, PA) is an important component in a mobile communication system. As a final amplification unit of a transmit channel, the power amplifier is configured to amplify a low-power radio frequency signal and then send the amplified signal to an antenna for transmission.

With the advent of the 5th generation mobile communication technology (5th generation mobile communication technology, 5G), in recent years, terminal devices raise increasingly high requirements on performance of the power amplifier. However, because phases and amplitudes of the radio frequency signal have a spatial distribution characteristic, phases and amplitudes of radio frequency currents and voltages in the power amplifier are prone to be different. Consequently, radio frequency performance, robustness, stability, and the like of the power amplifier deteriorate.

Therefore, there is an urgent need to figure out how to improve uniformity of phases and amplitudes of the radio frequency currents and voltages in the power amplifier without increasing complexity of preparing the power amplifier.

### SUMMARY

Embodiments of this application provide a radio frequency power assembly and an electronic device, to implement an interconnection between chips in the radio frequency power assembly by using a planar structure design, and effectively reduce complexity of preparing the radio frequency power assembly.

To achieve the foregoing objectives, the following technical solutions are used in embodiments of this application.

According to a first aspect, a radio frequency power assembly is provided. The radio frequency power assembly includes a substrate, a first chip, a second chip, an insulation layer, at least three conductive blocks, a first connection part, and a second connection part.

The first chip and the second chip are disposed on a same side of the substrate, where the first chip and the second chip are arranged in a first direction, and the first direction is parallel to the substrate. The insulation layer is at least partially disposed on a side that is of the first chip and the second chip and that is away from the substrate. The at least three conductive blocks are disposed on a side that is of the insulation layer and that is away from the substrate, where the at least three conductive blocks are spaced and arranged in a second direction, and the second direction is parallel to the substrate and intersects with the first direction. One end of the first connection part penetrates the insulation layer and is electrically connected to the first chip, and the other end is electrically connected to one end of a conductive block; and one end of the second connection part penetrates the insulation layer and is electrically connected to the second chip, and the other end is electrically connected to the other end of the conductive block. Areas of surfaces that are of at least two of the three conductive blocks and that are away from the substrate are different.

In the radio frequency power assembly provided in this embodiment of this application, the insulation layer is disposed on the first chip and the second chip, the conductive block is disposed on the insulation layer, and the conductive block is used to implement an electrical connection between the first chip and the second chip. In this way, when the electrical connection between the first chip and the second chip is implemented, a radio frequency power assembly with a planar design is provided. A plurality of conductive blocks may be formed in a single process without an additional processing procedure (for example, a refined design procedure of a signal line arc height). This reduces complexity of preparing the radio frequency power assembly, and can further adjust an equivalent inductance of the radio frequency power assembly by designing an area of the conductive block.

Areas of at least two of the three conductive blocks are set to be different, so that equivalent inductances (especially self-inductances) corresponding to different conductive blocks are controlled to be different, to adjust currents that are not uniformly distributed. For example, an area of a conductive block is reduced at a position with a large radio frequency current, and an area of a conductive block is increased at a position with a small radio frequency current, so that magnitudes of radio frequency currents output by the at least three conductive blocks tend to be consistent to implement uniform distribution, and signal phases and amplitudes at different positions are synchronized, thereby reducing signal flowing inside the radio frequency power assembly, and improving electrical performance of the radio frequency power assembly.

In a possible implementation of the first aspect, the conductive block extends from the first connection part to the second connection part, and a width of the conductive block is a size of the conductive block in a direction perpendicular to an extension path and parallel to the substrate. Widths of at least two of the three conductive blocks are different.

A designed width of each conductive block is determined by spatial distribution of a signal voltage and current at a position of the conductive block. A width of a conductive block is reduced at a position with a large current, to increase an equivalent inductance (especially a self-inductance) generated by the conductive block, so as to reduce a magnitude of the current transmitted by the conductive block. Similarly, a width of a conductive block is increased at a position with a small current. In this way, currents output by the conductive blocks 4 can be the same.

In a possible implementation of the first aspect, the conductive block extends from the first connection part to the second connection part, and a length of the conductive block is a maximum size of the conductive block in the extension path. Lengths of at least two of the three conductive blocks are different.

A length of a conductive block is increased at a position with a large current, to increase an equivalent inductance (especially a self-inductance) generated by the conductive block, so as to reduce a magnitude of the current transmitted by the conductive block. Similarly, a length of a conductive block is reduced at a position with a small current. In this way, currents output by the conductive blocks are the same.

In a possible implementation of the first aspect, the conductive block is in a rectangular shape extending in the first direction. Alternatively, at least one of the three conductive blocks is in a fold line shape. That is, the conductive block may include a plurality of deformation manners.

In a possible implementation of the first aspect, at least one of the three conductive blocks is in an arc shape, where curvatures of at least two conductive blocks are different.

Curvatures of at least two conductive blocks are set to be different, so that total lengths of the at least two conductive blocks can also be different. For example, when a distance between two ends is the same for all the conductive blocks, a larger curvature indicates a longer total length of a conductive block, and a smaller equivalent inductance (especially self-inductance) corresponding to the conductive block.

It may be understood that a technical effect brought by adjusting the curvature of the conductive block is the same as a technical effect brought by adjusting the length of the conductive block. Details are not described herein again.

In a possible implementation of the first aspect, the conductive block includes a first sub-part and a second sub-part that are sequentially connected in the first direction, widths and/or lengths of a plurality of first sub-parts corresponding to the at least three conductive blocks are the same, and widths and/or lengths of second sub-parts corresponding to at least two of the three conductive blocks are different. That is, only a part of positions of a single conductive block may be deformed, to provide more deformation manners for the conductive block.

In a possible implementation of the first aspect, thicknesses of at least two of the three conductive blocks are different; the thickness of the conductive block is a size of the conductive block in a third direction; and the third direction is perpendicular to a surface that is of the insulation layer and that is away from the substrate.

A larger thickness of a conductive block indicates a larger cross-sectional area of the conductive block through which a current passes, so that an equivalent inductance (especially a self-inductance) of the conductive block can be reduced, and the current passing through the conductive block can be increased.

It may be understood that a technical effect brought by adjusting the thickness of the conductive block is the same as a technical effect brought by adjusting the width of the conductive block. Details are not described herein again.

In a possible implementation of the first aspect, in the at least three conductive blocks, a spacing between at least one pair of adjacently arranged conductive blocks is different from a spacing between another pair of adjacently arranged conductive blocks.

A spacing between each pair of adjacently arranged conductive blocks is determined by spatial distribution of a signal voltage and current at a position of the conductive blocks. A spacing between two adjacent conductive blocks is reduced at a position with a large current, to increase an equivalent inductance (especially a mutual inductance) generated between the two adjacent conductive blocks, so as to reduce a magnitude of the current transmitted between the two adjacent conductive blocks. Similarly, a spacing between two adjacent conductive blocks is increased at a position with a small current. In this way, currents output by the conductive blocks are approximately the same.

In a possible implementation of the first aspect, the at least three conductive blocks are symmetrically arranged about a reference line serving as an axis of symmetry, and the reference line is parallel to the substrate and parallel to the first direction.

The at least three conductive blocks are symmetrically arranged about the reference line serving as the axis of symmetry, so that equivalent inductances generated at different positions of the at least three conductive blocks can be approximately the same, thereby improving uniformity of phases and amplitudes of radio frequency currents and voltages corresponding to the conductive blocks.

In a possible implementation of the first aspect, the first chip and the first connection part are integrally disposed, and the second chip and the second connection part are integrally disposed; or the conductive block, the first connection part, and the second connection part are integrally disposed.

In a possible implementation of the first aspect, the radio frequency power assembly further includes at least one electronic element, disposed on the side that is of the insulation layer and that is away from the substrate. The conductive block is electrically connected to the first connection part through the electronic element, and/or the conductive block is electrically connected to the second connection part through the electronic element.

In other words, the electronic element and the conductive block may be used together as a medium for radio frequency current transmission, so that a radio frequency current can be adjusted by adjusting the electronic element.

In a possible implementation of the first aspect, the radio frequency power assembly includes a plurality of second chips, and the plurality of second chips are respectively disposed on different sides of the first chip.

In other words, the radio frequency power assembly provided in this embodiment of this application is not limited to including one or two chips. The radio frequency power assembly may include a plurality of chips. Any two chips that need to be electrically connected can be interconnected through the conductive block provided in the foregoing embodiment, and an equivalent inductance can be controlled and adjusted.

In a possible implementation of the first aspect, the radio frequency power assembly includes a plurality of unit modules, where each unit module includes the first chip, the second chip, the insulation layer, the conductive block, the first connection part, and the second connection part. The plurality of unit modules are arranged in the first direction and/or the second direction.

In other words, devices in the radio frequency power assembly provided in this embodiment of this application may be added in the first direction X or the second direction Y, so that the radio frequency power assembly can be flexibly used in a plurality of different application scenarios.

According to a second aspect, a radio frequency power assembly is provided. The radio frequency power assembly includes a substrate, a first chip, a second chip, an insulation layer, at least three conductive blocks, a first connection part, and a second connection part.

The first chip and the second chip are disposed on a same side of the substrate, where the first chip and the second chip are arranged in a first direction, and the first direction is parallel to the substrate. The insulation layer is at least partially disposed on a side that is of the first chip and the second chip and that is away from the substrate. The at least three conductive blocks are disposed on a side that is of the insulation layer and that is away from the substrate, where the at least three conductive blocks are spaced and arranged in a second direction, and the second direction is parallel to the substrate and intersects with the first direction. One end of the first connection part penetrates the insulation layer and is electrically connected to the first chip, and the other end is electrically connected to one end of a conductive block; and one end of the second connection part penetrates the insulation layer and is electrically connected to the second chip, and the other end is electrically connected to the other end of the conductive block. In the at least three conductive blocks, a spacing between at least one pair of adjacently arranged conductive blocks is different from a spacing between another pair of adjacently arranged conductive blocks.

Similar to the radio frequency power assembly provided in the first aspect, the radio frequency power assembly provided in the second aspect also has low preparation difficulty. In addition, a spacing between at least one pair of adjacently arranged conductive blocks is set to be different from a spacing between another pair of adjacently arranged conductive blocks, so that equivalent inductances (especially mutual inductances) corresponding to different conductive blocks are controlled and adjusted. In this way, phases and amplitudes of radio frequency signals output by the at least three conductive blocks tend to be consistent to implement uniform distribution, thereby reducing signal flowing inside the radio frequency power assembly, and improving electrical performance of the radio frequency power assembly.

According to a third aspect, an electronic device is provided. The electronic device includes an antenna and the radio frequency power assembly provided in any embodiment of the first aspect. The antenna is coupled to the radio frequency power assembly.

For a technical effect brought by a preparation method of the electronic device in the third aspect, refer to the technical effects brought by the design manners of the radio frequency power assemblies in the first aspect and the second aspect. Details are not described herein again.

### BRIEF DESCRIPTION OF DRAWINGS

FIG. 1 is a diagram of a structure of an electronic device according to an embodiment of this application;
FIG. 2 is a diagram of a structure of a radio frequency power assembly according to an embodiment of this application;
FIG. 3 is a cross-sectional view along a sectional line A-A' in FIG. 2;
FIG. 4 is a top view of a radio frequency power assembly according to an embodiment of this application;
FIG. 5 is another cross-sectional view along a sectional line A-A' in FIG. 2;
FIG. 6 is another top view of a radio frequency power assembly according to an embodiment of this application;
FIG. 7 is another top view of a radio frequency power assembly according to an embodiment of this application;
FIG. 8 is another top view of a radio frequency power assembly according to an embodiment of this application;
FIG. 9 is another top view of a radio frequency power assembly according to an embodiment of this application;
FIG. 10 is a cross-sectional view along a sectional line B-B' in FIG. 2;
FIG. 11 is another top view of a radio frequency power assembly according to an embodiment of this application;
FIG. 12 is another top view of a radio frequency power assembly according to an embodiment of this application;
FIG. 13 is another top view of a radio frequency power assembly according to an embodiment of this application;
FIG. 14 is another cross-sectional view along a sectional line A-A' in FIG. 2;
FIG. 15 is another top view of a radio frequency power assembly according to an embodiment of this application;
FIG. 16 is another cross-sectional view along a sectional line A-A' in FIG. 2;
FIG. 17 is another cross-sectional view along a sectional line A-A' in FIG. 2;
FIG. 18 is another top view of a radio frequency power assembly according to an embodiment of this application; and
FIG. 19 is another top view of a radio frequency power assembly according to an embodiment of this application.

### DESCRIPTION OF EMBODIMENTS

The following clearly and completely describes technical solutions in some embodiments of this application with reference to the accompanying drawings. It is clear that the described embodiments are merely some rather than all embodiments of this application. All other embodiments obtained by a person of ordinary skill in the art based on embodiments of this application shall fall within the protection scope of this application.

In descriptions of this application, it should be understood that orientations or position relationships indicated by terms such as "center", "above", "below", "front", "rear", "left", "right", "vertical", "horizontal", "top", "bottom", "inside", and "outside" are based on the orientations or the position relationships shown in the accompanying drawings, and are merely intended to describe this application and simplify the descriptions, but not intended to indicate or imply that an indicated apparatus or element shall have a specific direction or be constructed and operated in a specific orientation. Therefore, such terms cannot be understood as a limitation on this application.

Unless otherwise required in the context, throughout the entire specification and claims, the term "include" is interpreted as "open and inclusive", that is, "include but not limited to". In descriptions of this specification, terms such as "an embodiment", "some embodiments", "an example embodiment", "an example", or "some examples" are intended to indicate that a specific feature, structure, material, or characteristic related to the embodiment or example are included in at least one embodiment or example of this application. The schematic representations of the foregoing terms do not necessarily mean a same embodiment or example. In addition, the specific feature, structure, material, or characteristic may be included in any one or more embodiments or examples in any appropriate manner.

The terms such as "first" and "second" mentioned below are merely intended for a purpose of description, and shall not be understood as an indication or implication of relative importance or implicit indication of a quantity of indicated technical features. Therefore, a feature limited by "first" or "second" may explicitly or implicitly include one or more features. In descriptions of embodiments of this application, unless otherwise specified, "a plurality of" means two or more.

When some embodiments are described, expressions of "coupling" and "connection" and their extensions may be used. The terms "coupling" and "connection" should be understood in a broad sense. For example, the "connection" may be a fixed connection, a detachable connection, or an integral connection, or may be a direct connection, or an indirect connection implemented through an intermediate medium. Embodiments disclosed herein are not necessarily limited to content of this specification.

"At least one of A, B, and C" and "at least one of A, B, or C" have a same meaning, and both include the following combinations of A, B, and C: only A, only B, only C, a combination of A and B, a combination of A and C, a combination of B and C, and a combination of A, B, and C.

"A and/or B" includes the following three combinations: only A, only B, and a combination of A and B.

As used herein, "parallel", "perpendicular to", and "equal to" include described cases and similar cases. A range of this similar case is in an acceptable deviation range. The acceptable deviation range is determined by a person of ordinary skill in the art by considering an error (namely, a limitation of a measurement system) related to measurement being discussed and measurement of a specific quantity. For example, "parallel" includes "absolutely parallel" and "approximately parallel", and an acceptable deviation range of "approximately parallel" may be, for example, a deviation within 5°. "Perpendicular to" includes "absolutely perpendicular to" and "approximately perpendicular to", and an acceptable deviation range of "approximately perpendicular to" may also be, for example, a deviation within 5°. "Equal to" includes "absolutely equal to" and "approximately equal to". An acceptable deviation range of "approximately equal to" may be that, for example, a difference between two equal objects is less than or equal to 5% of either of the two objects.

Example implementations are described herein with reference to sectional views and/or plane views that are used as idealized example accompanying drawings. In the accompanying drawings, for clarity, thicknesses of layers and regions are increased. Therefore, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. Therefore, the regions shown in the accompanying drawings are essentially examples, and shapes of the regions are not intended to show actual shapes of regions of a device, and are not intended to limit a scope of the example implementations.

In addition, a scenario described in embodiments of this application is intended to describe the technical solutions in embodiments of this application more clearly, but does not constitute a limitation on the technical solutions provided in embodiments of this application. A person of ordinary skill in the art may learn that as a new scenario emerges, the technical solutions provided in embodiments of this application are also applicable to a similar technical problem.

Embodiments of this application provide an electronic device. The technical solutions of this application may be applied to various electronic devices including a radio frequency power amplifier. The electronic device may be deployed on land, including an indoor or outdoor electronic device, and a handheld or vehicle-mounted electronic device; may alternatively be deployed on water (for example, on a ship); or may be deployed in the air (for example, on an airplane, a balloon, or a satellite). For example, the electronic device may be a terminal or a base station. The terminal includes but is not limited to a mobile phone (Mobile Phone), a tablet computer, a notebook computer, a palmtop computer, a mobile internet device (Mobile Internet Device, MID), a wearable device (for example, a smartwatch, a smart band, or a pedometer), a vehicle-mounted device (for example, a vehicle, a bicycle, an electric vehicle, an airplane, a ship, a train, or a high-speed rail vehicle), a virtual reality (Virtual Reality, VR) device, an augmented reality (Augmented Reality, AR) device, a wireless terminal in industrial control (Industrial Control), a smart home device (for example, a refrigerator, a television, an air conditioner, or an electric meter), a smart robot, a workshop device, a wireless terminal in self-driving (Self-driving), a wireless terminal in remote medical surgery (Remote Medical Surgery), a wireless terminal in a smart grid (Smart Grid), a wireless terminal in transportation safety (Transportation Safety), a wireless terminal in a smart city (Smart City), a wireless terminal in a smart home (Smart Home), a flight device (for example, a smart robot, a hot air balloon, an uncrewed aerial vehicle, or an airplane), a radio frequency front end module, or the like.

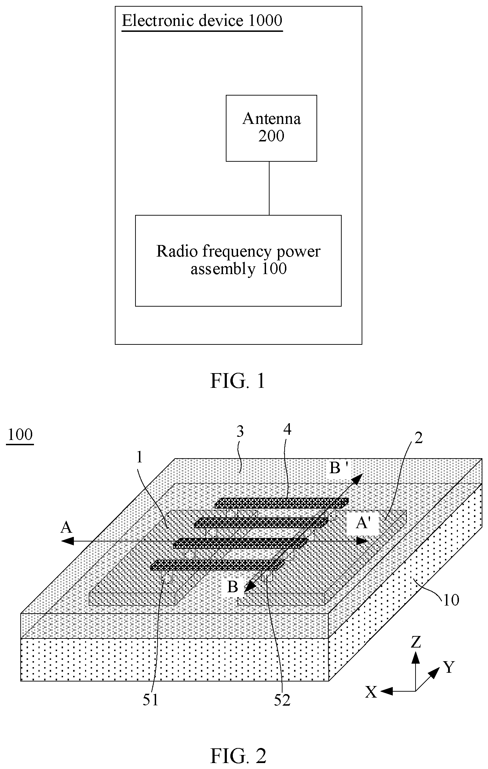

FIG. 1 is an example diagram of a structure of an electronic device according to an embodiment of this application. As shown in FIG. 1, the electronic device 1000 includes a radio frequency power assembly 100 and an antenna 200.

The radio frequency power assembly 100 is coupled to the antenna 200.

It should be noted that "coupled" herein may mean that the radio frequency power assembly 100 is directly connected to the antenna 200, or may mean that the radio frequency power assembly 100 is indirectly connected to the antenna 200, or may mean that the radio frequency power assembly 100 and the antenna 200 are not in contact but affect each other. A specific coupling manner of the radio frequency power assembly 100 and the antenna 200 is not limited in embodiments of this application.

The radio frequency power assembly 100 is configured to amplify a radio frequency signal and transmit an amplified radio frequency signal to the antenna 200, and the antenna 200 is configured to radiate the amplified radio frequency signal to the outside.

It may be understood that the electronic device 1000 may include one or more antennas 200.

When the electronic device 1000 includes a plurality of antennas 200, one antenna 200 may correspond to one radio frequency power assembly 100, or one antenna 200 may correspond to a plurality of radio frequency power assemblies 100, or a plurality of antennas 200 may share one radio frequency power assembly 100. All application scenarios in a related technology are applicable to embodiments of this application.

It may be understood that the structure of the electronic device 1000 shown in FIG. 1 does not constitute a specific limitation on the electronic device 1000. The electronic device 1000 may include more components than those shown in FIG. 1, for example, may further include a packaging structure and an auxiliary component (for example, a passive device IPD or a transmission line) (not shown in the figure), or may combine a part of the components shown in FIG. 1, or may have a component arrangement different from that shown in FIG. 1.

Embodiments of this application further provide a radio frequency power assembly 100.

The radio frequency power assembly 100 may be integrated into any electronic device 1000, for example, may be integrated into any network element device that needs to perform signal power amplification, like a base station. Specifically, the radio frequency power assembly 100 provided in embodiments of this application may work in a radio frequency part of the base station, for example, may be disposed in a radio remote unit (Radio Remote Unit, RRU for short) of the base station. The base station may be a base transceiver station (Base Transceiver Station, BTS for short) in a GSM system or a CDMA system, or a NodeB (NodeB) in a WCDMA system, or an evolved NodeB (e-NodeB, evolved NodeB) in an LTE system, or a similar device in a subsequent communication system evolved from LTE.

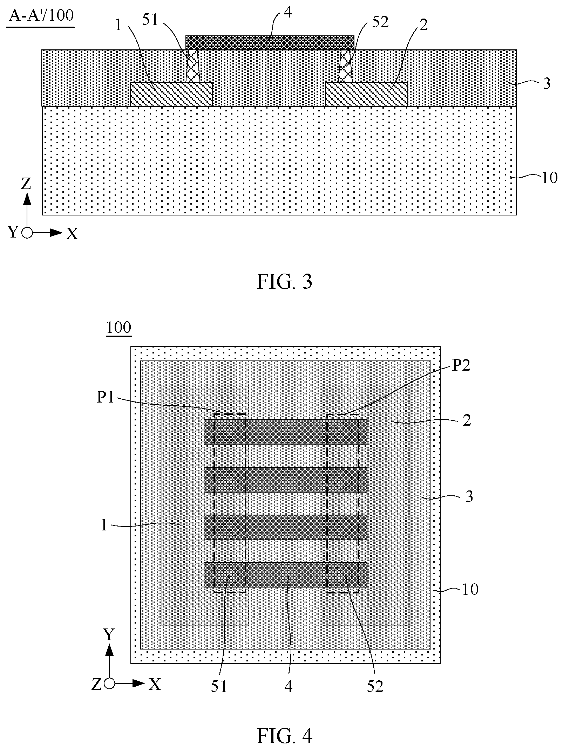

FIG. 2 is a diagram of a structure of a radio frequency power assembly 100 according to an embodiment of this application; FIG. 3 is a cross-sectional view along a sectional line A-A' in FIG. 2; and FIG. 4 is a top view of a radio frequency power assembly 100 according to an embodiment of this application.

In some embodiments, as shown in FIG. 2, FIG. 3, and FIG. 4, the radio frequency power assembly 100 may include a substrate 10, a first chip 1, a second chip 2, an insulation layer 3, at least three conductive blocks 4, a first connection part 51, and a second connection part 52.

For example, the substrate 10 may be a flange, to serve as a carrier so as to support preparation of structures such as the first chip 1, the second chip 2, and the insulation layer 3.

It may be understood that the substrate 10 may alternatively be of another structure, for example, may be a wafer substrate, or may be another carrier that can bear, bond, or fasten the first chip 1 and the second chip 2 on a surface. This is not limited in embodiments of this application.

For example, a material of the substrate 10 may include a metal material, a semiconductor material, another material that can provide specific support force, or the like. This is not limited in embodiments of this application.

For example, the substrate 10 may be electrically conductive, and/or may be thermally conductive, to reduce a probability of electrostatic discharge, or enhance a heat dissipation capability, thereby improving electrical performance of the radio frequency power assembly 100.

It may be understood that, with reference to FIG. 2 and FIG. 3, a surface, of the substrate 10, on which the first chip 1 and the second chip 2 are disposed is approximately planar, to reduce complexity of preparing the structures such as the first chip 1, the second chip 2, and the insulation layer 3.

Refer to FIG. 2, FIG. 3, and FIG. 4. The first chip 1 and the second chip 2 are disposed on a same side of the substrate 10, and the first chip 1 and the second chip 2 are arranged in a first direction X.

The first direction X is parallel to the substrate 10.

For example, both the first chip 1 and the second chip 2 may be power amplification chips. The power amplification chip may be an active device. For example, the power amplification chip may include a structure like a field-effect transistor. As a core device for power amplification, the power amplification chip is configured to amplify a radio frequency power, so that a sufficiently large radio frequency output power can be obtained.

Alternatively, for example, both the first chip 1 and the second chip 2 may be capacitor chips. The capacitor chip may be a passive device, and may be equivalent to a capacitor.

For example, the capacitor chip may include a single layer ceramic capacitor (Single Layer Ceramic Capacitor, SLCC for short), a multi layer ceramic capacitor (Multi Layer Ceramic Capacitor, MLCC for short), a semiconductor capacitor (Metal-Oxide-Semiconductor Capacitor, MOSCAP for short), and the like.

Alternatively, for example, one of the first chip 1 and the second chip 2 is a power amplification chip, and the other is a capacitor chip.

For example, refer to FIG. 4. The first chip 1 may include a first binding region P1, the second chip 2 may include a second binding region P2. The first binding region P1 is used to implement binding and a connection between the first chip 1 and an external device. Similarly, the second binding region P2 is used to implement binding and a connection between the second chip 2 and an external device.

For example, the first chip 1 may include a plurality of first binding regions P1. For example, four first binding regions P1 are sequentially arranged along four sides of the first chip 1 (where this is not shown in the figure, and only one first binding region P1 is used as an example for illustration in FIG. 4). Similarly, the second chip 2 may also include a plurality of second binding regions P2.

For example, the first binding region P1 and the second binding region P2 may include a plurality of pads.

It may be understood that the pad is a part of a conductive structure that is of the first chip 1 and that is exposed in the first binding region P1 or a part of a conductive structure that is of the second chip 2 and that is exposed in the second binding region P2. For example, the pad may be at least a part of a pin, a capacitor plate, a microstrip transmission line, or another conductive structure exposed in the first binding region P1 or the second binding region P2.

For example, the first chip 1 may include a plurality of first pins disposed in the first binding region P1, and the first pin is configured to implement an electrical connection between the first chip 1 and another structure. Similarly, the second chip 2 may include a plurality of second pins disposed in the second binding region P2, and the second pin is configured to implement an electrical connection between the second chip 2 and another structure.

For example, the plurality of first pins are in one-to-one correspondence with the plurality of second pins, to subsequently implement an electrical connection between the first chip 1 and the second chip 2 through the first pin and the second pin.

Refer to FIG. 2 and FIG. 3. The insulation layer 3 is at least partially disposed on a side that is of the first chip 1 and the second chip 2 and that is away from the substrate 10.

For example, refer to FIG. 2 and FIG. 3. The insulation layer 3 is further at least partially disposed on a side surface that is of the first chip 1 and the second chip 2 and that is perpendicular to the substrate 10. For example, the insulation layer 3 is further at least partially disposed between the first chip 1 and the second chip 2. That is, the insulation layer 3 surrounds the first chip 1 and the second chip 2, to protect the first chip 1 and the second chip 2, and avoid an unexpected electrical connection between the first chip 1 and the second chip 2 and another conductive structure.

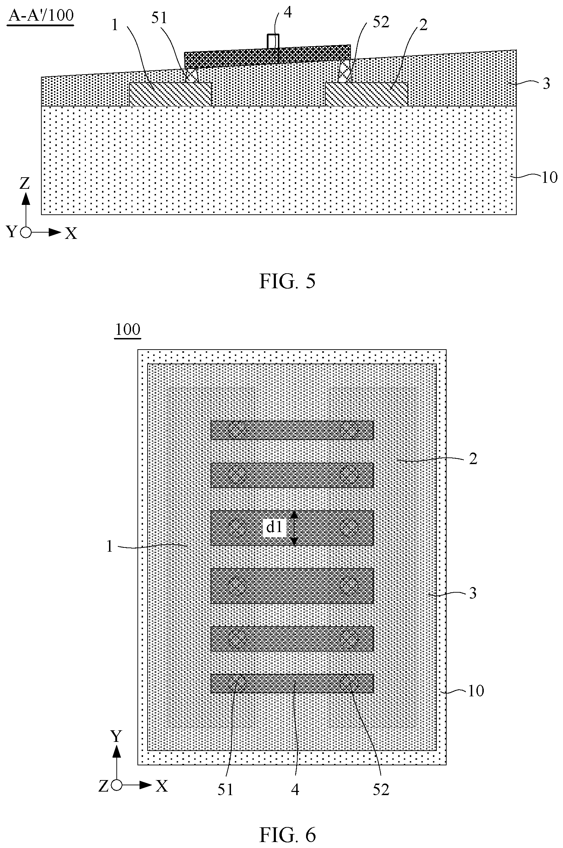

For example, refer to FIG. 5. An extension direction of a surface that is of the insulation layer 3 and that is away from the substrate 10 may intersect with an extension direction of the substrate 10. In other words, the insulation layer 3 may be designed in an inclined manner, to be flexibly applicable to different application scenarios.

Refer to FIG. 2, FIG. 3, and FIG. 4. A plurality of (at least three, where the same applies to the following descriptions) conductive blocks 4 are disposed on a side that is of the insulation layer 3 and that is away from the substrate 10, where the plurality of conductive blocks 4 are spaced and arranged in a second direction Y.

The second direction Y is parallel to the substrate 10 and intersects with the first direction X. For example, the second direction Y is perpendicular to the first direction X.

For example, refer to FIG. 2 and FIG. 4. The conductive block 4 is in a strip shape.

For example, the conductive block 4 may be in a rectangular shape, a fold line shape, an arc shape, or the like, or may be in another shape that can be used to implement an interconnection between the first chip 1 and the second chip 2. This is not limited in embodiments of this application.

It may be understood that one end of the conductive block 4 is configured to be electrically connected to the first chip 1 (for example, the first pin), and the other end is electrically connected to the second chip 2 (for example, the second pin), to implement the electrical connection between the first chip 1 and the second chip 2, so as to implement impedance matching, direct current transmission, radio frequency signal transmission, and the like between the first chip 1 and the second chip 2.

For example, the conductive block 4 may be a coating, a thin film, or the like.

For example, the conductive block 4 may be prepared by using a patterning process. For example, the conductive block 4 may be prepared by using a photoetching process, or the conductive block 4 may be prepared by using an electroplating process or a sputtering process.

It may be understood that, when a current flows in the conductive block 4, the conductive block 4 generates a self-inductance (Self-inductance), and a mutual inductance (Mutual inductance) is further generated between different conductive blocks 4. In an equivalent circuit topology (a lumped parameter) of the radio frequency power assembly 100, the conductive block 4 may be equivalent to a matching inductor, and an equivalent inductance of the equivalent inductance depends on the self-inductance of the conductive block 4 and the mutual inductance between the conductive blocks 4.

Refer to FIG. 2, FIG. 3, and FIG. 4. One end of the first connection part 51 penetrates the insulation layer 3 and is electrically connected to the first chip 1, and the other end is electrically connected to one end of the conductive block 4.

Similarly, refer to FIG. 2, FIG. 3, and FIG. 4. One end of the second connection part 52 penetrates the insulation layer 3 and is electrically connected to the second chip 2, and the other end is electrically connected to the other end of the conductive block 4.

That is, one end of the conductive block 4 is electrically connected to the first chip 1 through the first connection part 51, and the other end of the conductive block 4 is electrically connected to the second chip 2 through the second connection part 52, to implement the electrical connection between the first chip 1 and the second chip 2.

For example, the first connection part 51 and the first chip 1 may be integrally disposed. For example, the first connection part 51 and the first pin in the first chip 1 are integrally disposed. In other words, the first pin in the first chip 1 is led out after penetrating the insulation layer 3, and is electrically connected to the conductive block 4. A part, of the first pin, embedded in the insulation layer 3 is used as the first connection part 51.

Similarly, the second connection part 52 and the second chip 2 may be integrally disposed, and this is similar to the first connection part 51. Details are not described herein again.

For example, the first connection part 51, the second connection part 52, and the conductive block 4 may alternatively be integrally disposed. For example, in a preparation process, holes are formed on the insulation layer 3, and a conductive material is deposited on the insulation layer 3, so that a conductive material filled in the holes of the insulation layer 3 and the conductive material deposited on the insulation layer 3 are integrally formed. The conductive material filled in the holes of the insulation layer 3 is used as the first connection part 51 and the second connection part 52, and the conductive material deposited on the insulation layer 3 is used as the conductive block 4.

In a related technology, the first chip is connected to the second chip through a plurality of signal lines. Because a phase and an amplitude of a radio frequency signal of the radio frequency power assembly have a spatial distribution characteristic, and relative position relationships (that is, spatial distribution) between the plurality of signal lines are different, equivalent inductances (including self-inductances and a mutual inductance) between the plurality of signal lines are also different. Therefore, phases and amplitudes of radio frequency currents and voltages on the plurality of signal lines are different, and this difference affects radio frequency performance, robustness, stability, and the like of the radio frequency power assembly.

In a related technology, an arc height of the signal line (a height at which the signal line is arched in a direction away from the substrate), an angle at which the signal line is tilted after the signal line is arched, or the like is adjusted, to adjust the self-inductance of the signal line and the mutual inductance between the plurality of signal lines, so that the phases, the amplitudes, and the like of the radio frequency currents and voltages corresponding to the plurality of signal lines are uniformly distributed.

However, a three-dimensional arrangement of the arched signal line reduces structural stability of the radio frequency power assembly, and further increases complexity of packaging the radio frequency power assembly, and this is not conducive to evolution of a packaging form.

In the radio frequency power assembly 100 provided in embodiments of this application, the insulation layer 3 is disposed on the first chip 1 and the second chip 2, the conductive block 4 is disposed on the insulation layer 3, and the conductive block 4 is used to implement the electrical connection between the first chip 1 and the second chip 2. In this way, when the electrical connection between the first chip 1 and the second chip 2 is implemented, a radio frequency power assembly 100 with a planar design is provided. The at least three conductive blocks 4 may be formed in a single process without an additional processing procedure (for example, a refined design procedure of a signal line arc height). This reduces complexity of preparing the radio frequency power assembly 100. In addition, in comparison with a signal line structure with a three-dimensional design, a structural design of the radio frequency power assembly 100 in embodiments of this application reduces subsequent complexity of packaging.

The radio frequency power assembly 100 provided in embodiments of this application may also implement uniform distribution of phases, amplitudes, and the like of radio frequency currents and voltages. A specific implementation is as follows.

FIG. 6 to FIG. 12 are some other diagrams of structures of a radio frequency power assembly 100 according to embodiments of this application.

In some embodiments, as shown in FIG. 6, FIG. 7, and FIG. 8, areas of surfaces that are of at least two of a plurality of (at least three, where the same applies to the following descriptions) conductive blocks 4 and that are parallel to a substrate 10 are different.

Areas of at least two of the plurality of conductive blocks 4 are set to be different, so that equivalent inductances (especially self-inductances) corresponding to different conductive blocks 4 are controlled to be different, to adjust currents that are not uniformly distributed. For example, an area of a conductive block 4 is reduced at a position with a large radio frequency current, and an area of a conductive block 4 is increased at a position with a small radio frequency current, so that magnitudes of radio frequency currents output by the plurality of conductive blocks 4 are the same to implement uniform distribution, and signal phases and amplitudes at different positions are synchronized, thereby reducing signal flowing, and improving electrical performance of the radio frequency power assembly 100.

In some embodiments, as shown in FIG. 6, the conductive block 4 extends from a first connection part 51 to a second connection part 52, a width d1 of the conductive block 4 is a size of the conductive block 4 in a direction perpendicular to an extension path and parallel to the substrate 10.

The "extension path" is a length extension direction of the conductive block 4. For example, when the conductive block 4 is in a rectangular shape, the extension path of the conductive block 4 is parallel to a first direction X; or when the conductive block 4 is in an arc shape, the extension path of the conductive block 4 is in an arc shape. In this case, different positions on the extension path correspond to different tangent extension directions.

Refer to FIG. 6. Widths d1 of at least two of the plurality of conductive blocks 4 are different.

For example, refer to FIG. 6. When the conductive block 4 is in a rectangular shape extending in the first direction X, the width d1 of the conductive block 4 is a size of the conductive block 4 in a second direction Y (perpendicular to the first direction X).

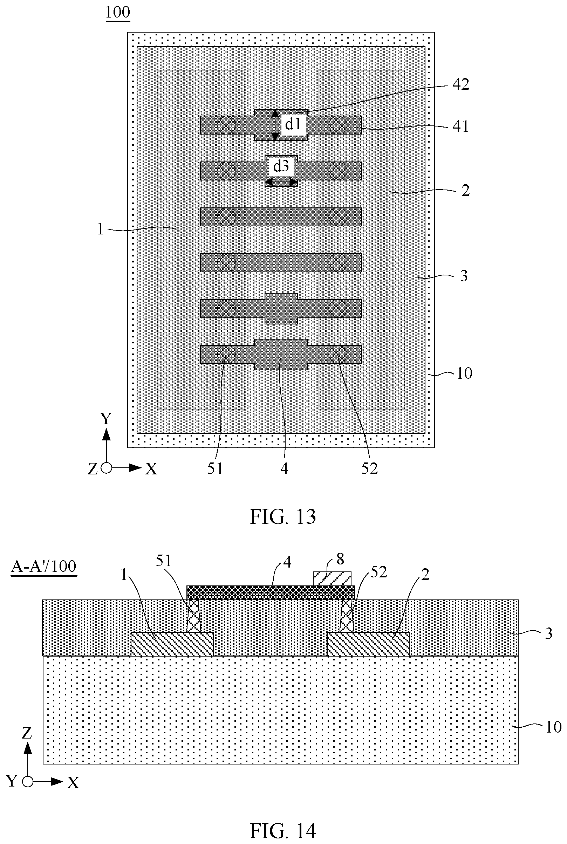

Alternatively, for example, refer to FIG. 13 below. The conductive block 4 may include a first sub-part 41 and a second sub-part 42, and the first sub-part 41 and the second sub-part 42 are sequentially connected in the first direction X. Widths d1 of a plurality of first sub-parts 41 corresponding to the plurality of conductive blocks 4 are the same. Widths d1 of second sub-parts 42 corresponding to at least two of the plurality of conductive blocks 4 are different (a width change is not shown in FIG. 13).

In other words, widths d1 at different positions of a single conductive block 4 are the same (when the conductive block 4 is in a rectangular shape), or a width d1 of a part of the conductive block 4 may not change (for example, the width d1 of the first sub-part 41 does not change), and only a width d1 of another part (for example, the second sub-part 42) of the conductive block 4 is deformed, to provide a plurality of deformation manners for the conductive block 4.

It may be understood that a designed width d1 of each conductive block 4 is determined by spatial distribution of a signal voltage and current at a position of the conductive block 4. A width d1 of a conductive block 4 is reduced at a position with a large current, to increase an equivalent inductance (especially a self-inductance) generated by the conductive block 4, so as to reduce a magnitude of the current transmitted by the conductive block 4. Similarly, a width d1 of a conductive block 4 is increased at a position with a small current. In this way, currents output by the conductive blocks 4 are the same.

For example, refer to FIG. 6. In a region in which the plurality of conductive blocks 4 are located, from a center of the region to two ends of the region in the second direction Y, the widths d1 of the conductive blocks 4 gradually decrease.

In the region in which the plurality of conductive blocks 4 are located, an equivalent inductance (especially a mutual inductance) between conductive blocks 4 located in the middle part of the region is large, and therefore a corresponding current at the position is small. However, equivalent inductances (especially mutual inductances) between conductive blocks 4 located at the two ends of the region in the second direction Y are small, and therefore corresponding currents at the two ends are large. From the center of the region to the two ends of the region in the second direction Y, the widths d1 of the conductive blocks 4 are set to gradually decrease, so that an equivalent inductance (especially a self-inductance) of a conductive block 4 located in the middle part of the region is small, and equivalent inductances (especially self-inductances) of conductive blocks 4 located at the two ends of the region in the second direction Y are large. Therefore, the corresponding current in the middle of the region adaptively increases, and the corresponding currents at the two ends of the region adaptively decrease, that is, magnitudes of currents corresponding to the conductive blocks 4 are approximately uniform.

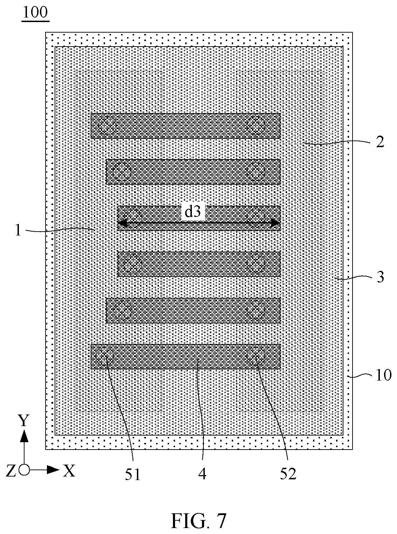

In some embodiments, refer to FIG. 7. The conductive block 4 extends from the first connection part 51 to the second connection part 52, and a length d3 of the conductive block 4 is a maximum size of the conductive block 4 in the extension path.

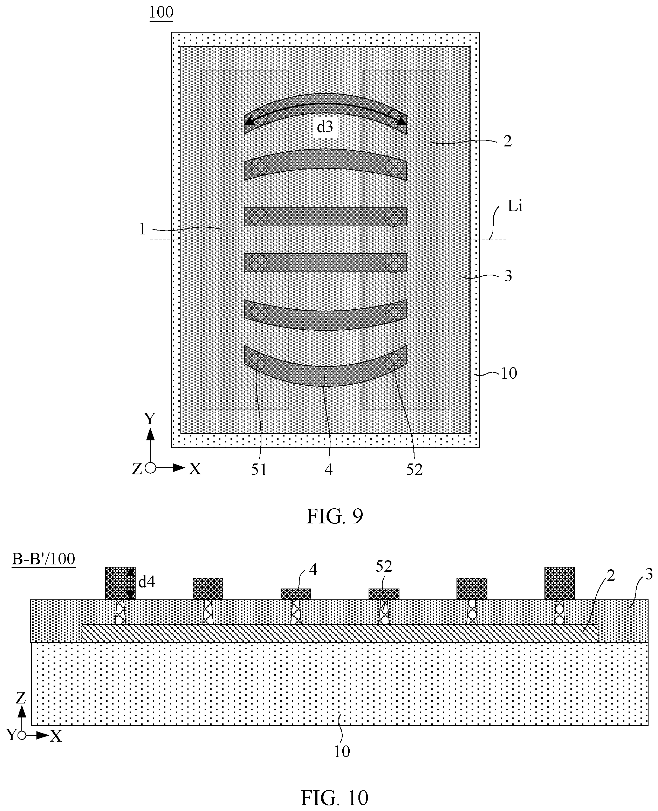

The "maximum size of the conductive block 4 in the extension path" is a sum of lengths at different positions of the conductive block 4 in the extension path. For example, when the conductive block 4 is in a rectangular shape extending in the first direction X, the maximum size (the length d3 of the conductive block 4) of the conductive block 4 in the extension path is a size of the conductive block 4 in the first direction X. Alternatively, for example, when a part of the conductive block 4 extends in the first direction X and the other part extends in the second direction Y, the length d3 of the conductive block 4 is a sum of a size in the first direction X of the part of the conductive block 4 extending in the first direction X and a size in the second direction Y of the part of the conductive block 4 extending in the second direction Y. When the conductive block 4 is in an arc shape, refer to FIG. 9. The length d3 of the conductive block 4 is approximately an arc length of the conductive block 4.

Refer to FIG. 7. Lengths d3 of at least two of the plurality of conductive blocks 4 are different.

For example, refer to FIG. 7. When the conductive block 4 is in a rectangular shape extending in the first direction X, the length d3 of the conductive block 4 is a size of the conductive block 4 in the first direction X.

Alternatively, for example, refer to FIG. 13 below. Lengths d3 of a plurality of first sub-parts 41 corresponding to the plurality of conductive blocks 4 are the same. Lengths d3 of second sub-parts 42 corresponding to at least two of the plurality of conductive blocks 4 are different.

That is, only a length d3 of a part (for example, the second sub-part 42) of the conductive block 4 may be deformed, to provide a plurality of deformation manners for the conductive block 4.

It may be understood that a designed length d3 of each conductive block 4 is determined by spatial distribution of a signal voltage and current at a position of the conductive block 4. A length d3 of a conductive block 4 is increased at a position with a large current, to increase a self-inductance generated by the conductive block 4, so as to reduce a magnitude of the current transmitted by the conductive block 4. Similarly, a length d3 of a conductive block 4 is reduced at a position with a small current. In this way, currents output by the conductive blocks 4 are the same.

For example, refer to FIG. 7. In a region in which the plurality of conductive blocks 4 are located, from a center of the region to two ends of the region in the second direction Y, the lengths d3 of the conductive blocks 4 gradually increase.

In the region in which the plurality of conductive blocks 4 are located, an equivalent inductance (especially a mutual inductance) between conductive blocks 4 located in the middle part of the region is large, and therefore a corresponding current at the position is small. However, equivalent inductances (especially mutual inductances) between conductive blocks 4 located at the two ends of the region in the second direction Y are small, and therefore corresponding currents at the two ends are large. From the center of the region to the two ends of the region in the second direction Y, the lengths d3 of the conductive blocks 4 are set to gradually increase, so that an equivalent inductance (especially a self-inductance) of a conductive block 4 located in the middle part of the region is small, and equivalent inductances (especially self-inductances) of conductive blocks 4 located at the two ends of the region in the second direction Y are large. Therefore, the corresponding current in the middle of the region adaptively increases, and the corresponding currents at the two ends of the region adaptively decrease, that is, magnitudes of currents corresponding to the conductive blocks 4 are approximately uniform.

For example, refer to FIG. 6 and FIG. 7. The conductive block 4 may be in a regular long strip shape. In other words, widths d1 at different positions of the conductive block 4 are approximately equal, or lengths d3 at different positions are approximately equal.

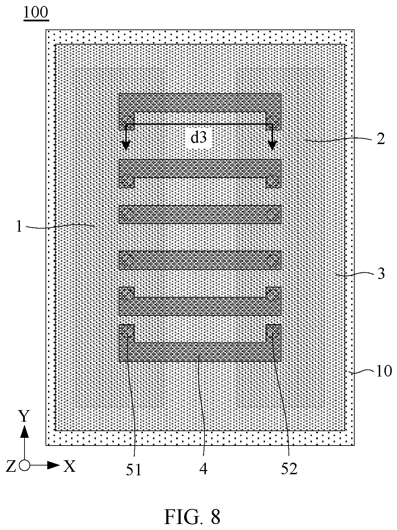

Alternatively, for example, refer to FIG. 8 and FIG. 9. The conductive block 4 may be in a fold line shape, an arc shape, or another shape.

In some embodiments, refer to FIG. 8. At least one of the plurality of conductive blocks 4 is in a fold line shape.

For example, refer to FIG. 8. A part of the at least one conductive block 4 extends in the first direction X, and another part extends in the second direction Y. Alternatively, in another embodiment, an extension direction of at least a part of the conductive block 4 intersects with the first direction X or the second direction Y. In other words, a folding direction of the conductive block 4 in a fold line shape is not limited in embodiments of this application, and any folding manner that can be used to extend the length d3 of the conductive block 4 falls within the protection scope of embodiments of this application.

Refer to FIG. 8. Lengths d3 of at least two conductive blocks 4 are different through a fold line arrangement.

In some embodiments, refer to FIG. 9. At least one of the plurality of conductive blocks 4 is in an arc shape Curvatures of at least two conductive blocks 4 are different.

Curvatures of at least two conductive blocks 4 are set to be different, so that total lengths d3 of the at least two conductive blocks 4 can also be different. For example, when a distance between two ends is the same for all the conductive blocks 4, a larger curvature indicates a longer total length d3 of a conductive block 4, and a smaller equivalent inductance (especially self-inductance) corresponding to the conductive block 4.

It may be understood that a technical effect brought by adjusting the curvature of the conductive block 4 is the same as a technical effect brought by adjusting the length d3 of the conductive block 4. Details are not described herein again.

For example, widths d1 at different positions of a single conductive block 4 in an arc shape may be the same or may be different.

For example, widths d1 of two conductive blocks 4 in an arc shape with different curvatures may also be different, that is, a deformation design of the curvature and a deformation design of the width d1 may be combined.

In some embodiments, refer to FIG. 10. Thicknesses d4 of at least two of the plurality of conductive blocks 4 are different.

Refer to FIG. 10. The thickness d4 of the conductive block 4 is a size of the conductive block 4 in a third direction Z.

Refer to FIG. 10. The third direction Z is perpendicular to a surface that is of the insulation layer 3 and that is away from the substrate 10.

It may be understood that a larger thickness d4 of a conductive block 4 indicates a larger cross-sectional area of the conductive block 4 through which a current passes, so that an equivalent inductance (especially a self-inductance) of the conductive block 4 can be reduced, and the current passing through the conductive block 4 can be increased.

It may be understood that a technical effect brought by adjusting the thickness d4 of the conductive block 4 is the same as a technical effect brought by adjusting the width d1 of the conductive block 4. Details are not described herein again.

For example, the thickness d4 of the conductive block 4 may be adjusted through a plurality of photoetching processes. For example, a plurality of depositions of conductive materials may be performed at a position of the conductive block 4 where a large thickness d4 is needed. Alternatively, for example, a plurality of electroplating or sputtering processes may be performed at a position of the conductive block 4 where a large thickness d4 is needed.

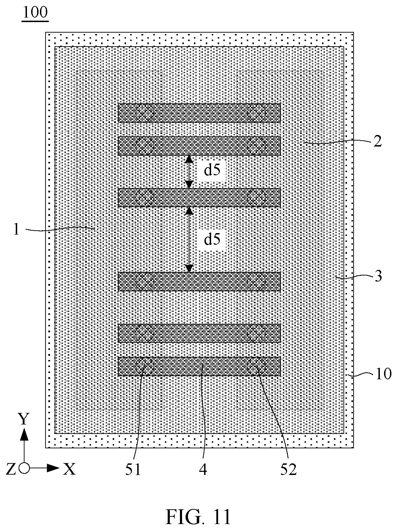

In some embodiments, refer to FIG. 11. In the plurality of conductive blocks 4, a spacing d5 between at least one pair of adjacently arranged conductive blocks 4 is different from a spacing d5 between another pair of adjacently arranged conductive blocks 4.

It may be understood that, a spacing d5 between each pair of adjacently arranged conductive blocks 4 is determined by spatial distribution of a signal voltage and current at a position of the conductive blocks 4. A spacing d5 between two adjacent conductive blocks 4 is reduced at a position with a large current, to increase an equivalent inductance (especially a mutual inductance) generated between any two conductive blocks 4, so as to reduce a magnitude of the current transmitted between the two adjacent conductive blocks 4. Similarly, a spacing d5 between two adjacent conductive blocks 4 is increased at a position with a small current. In this way, currents output by the conductive blocks 4 are approximately the same.

For example, refer to FIG. 11. In a region in which the plurality of conductive blocks 4 are located, from a center of the region to two ends of the region in the second direction Y, a spacing d5 between two adjacent conductive blocks 4 gradually decreases, so that equivalent inductances (especially mutual inductances) at corresponding positions of the conductive blocks 4 are approximately the same, and magnitudes of corresponding currents of the conductive blocks 4 may also be approximately uniform.

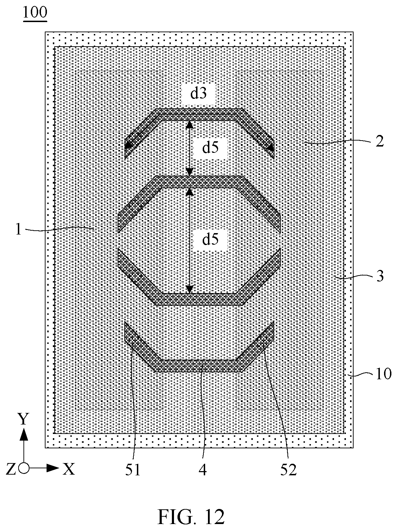

In some embodiments, a plurality of embodiments provided in this application may be randomly combined. For example, refer to FIG. 12. A shape of the conductive block 4 is deformed, so that spacings d5 between at least two pairs of adjacently arranged conductive blocks 4 may be different, and total lengths d3 of the at least two conductive blocks 4 may be different.

In some embodiments, related parameters (for example, the width d1, the length d3, and the thickness d4) of the conductive block 4 in the foregoing embodiments may sequentially change (for example, sequentially decrease or sequentially increase) in the second direction Y, or may change in a phase in the second direction Y (for example, a parameter changes once every two conductive blocks 4).

In a related technology, to improve uniformity of phases and amplitudes of radio frequency currents and voltages corresponding to a plurality of signal lines, an equivalent inductance (that is, a combination of a self-inductance and a mutual inductance) generated by the signal line needs to be adaptively and finely adjusted, for example, an arc height and an angle of the signal line need to be adjusted, and a fineness requirement is very high. Especially, as a chip size increases and a quantity of signal lines increases, more corresponding parameters need to be adjusted. In addition, because the signal line in the related technology is designed in a three-dimensional structure, high-precision adjustment needs to be performed one by one, and adjustment complexity is significant.

However, in the radio frequency power assembly 100 provided in embodiments of this application, a structure design of the conductive block 4 allows the conductive block 4 to be prepared in a planar manner, to implement integrated forming, and preparing complexity is low. In addition, based on the conductive block 4 designed in the planar manner in embodiments of this application, the equivalent inductance in the radio frequency power assembly 100 can be easily adjusted, to adjust phases and amplitudes of radio frequency currents and voltages corresponding to each conductive block 4, achieve voltage balance at all positions in regions corresponding to the plurality of conductive blocks 4, reduce signal flowing between nodes, and improve performance and robustness of the radio frequency power assembly 100.

In some embodiments, refer to FIG. 6, FIG. 7, FIG. 8, FIG. 9, FIG. 12, and the like. The conductive block 4 may be deformed at all positions, to adjust the phases and amplitudes of the radio frequency current and voltage.

Alternatively, in another embodiment, as shown in FIG. 13, only a part of positions (for example, the second sub-part 42) of the conductive block 4 may be deformed. For example, refer to FIG. 13. Only a part that is of the conductive block 4 and that is located between the first chip 1 and the second chip 2 is deformed, so that an area of the corresponding conductive block 4 is flexibly adjusted.

It may be understood that FIG. 6 to FIG. 13 merely provide examples of some possible deformation manners of the conductive block 4, and other deformation positions and deformation manners that can be used to adjust the self-inductance or the mutual inductance of the conductive block 4 fall within the protection scope of embodiments of this application.

In some embodiments, as shown in FIG. 9, the plurality of conductive blocks 4 are symmetrically arranged about a reference line Li serving as an axis of symmetry.

Refer to FIG. 9. The reference line Li is parallel to the substrate 10, and is parallel to the first direction X.

The plurality of conductive blocks 4 are symmetrically arranged about the reference line Li serving as the axis of symmetry, so that equivalent inductances generated at different positions of the plurality of conductive blocks 4 can be approximately the same, to thereby improving uniformity of phases and amplitudes of radio frequency currents and voltages corresponding to the conductive blocks 4.

In some embodiments, as shown in FIG. 14, FIG. 15, and FIG. 16, the radio frequency power assembly 100 further includes at least one electronic element 8, where the electronic element 8 is disposed on a side that is of the insulation layer 3 and that is away from the substrate 10.

For example, refer to FIG. 14, FIG. 15, and FIG. 16. The electronic element 8 may include one or more of a resistor, an inductor, a capacitor, or a sub-circuit.

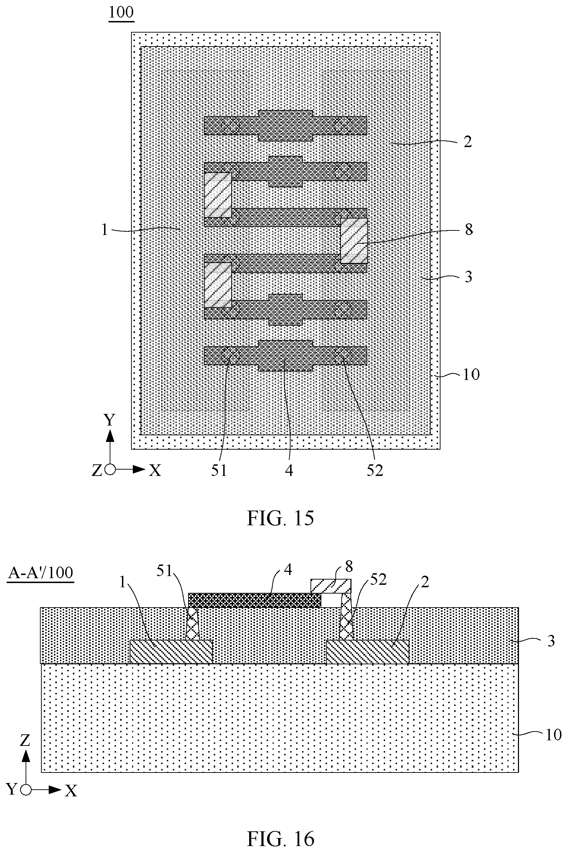

In some embodiments, as shown in FIG. 14 and FIG. 15, the electronic element 8 may be disposed on a side that is of the conductive block 4 and that is away from the substrate 10.

In some embodiments, as shown in FIG. 16, the conductive block 4 may be electrically connected to the first connection part 51 through the electronic element 8, and/or the conductive block 4 may be electrically connected to the second connection part 52 through the electronic element 8. That is, the electronic element 8 and the conductive block 4 may be used together as a medium for radio frequency current transmission, so that an amplitude and a phase of a radio frequency signal may be adjusted by adjusting some electronic elements 8.

For example, an equivalent inductance at a corresponding position may be adjusted by adjusting a disposition position of the electronic element 8. For example, an electronic element 8 with a large inductance is disposed at a position with a large current, to reduce the current at the position, so as to implement current adjustment.

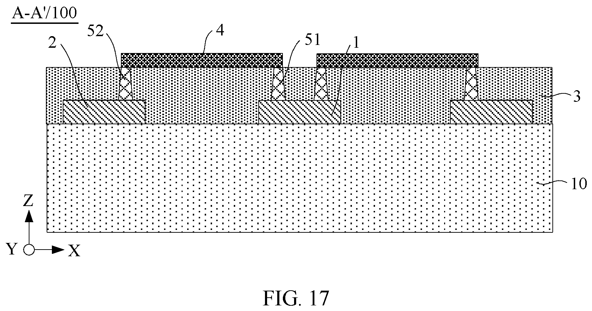

In some embodiments, as shown in FIG. 17, the radio frequency power assembly 100 includes a plurality of second chips 2, and the plurality of second chips 2 may be respectively disposed on different sides of the first chip 1.

For example, refer to FIG. 17. Orientations shown in FIG. 17 are used as an example, and two second chips 2 may be respectively disposed on a left side and a right side of the first chip 1.

That is, the radio frequency power assembly 100 provided in embodiments of this application is not limited to one or two chips. The radio frequency power assembly 100 may include a plurality of chips. Any two chips that need to be electrically connected can be interconnected through the conductive block 4 provided in the foregoing embodiments, and an equivalent inductance can be controlled and adjusted.

In the radio frequency power assembly, as a power increases, a multi-cell (multi-cell) design may be used. To be specific, a chip (for example, the first chip 1 or the second chip 2) is divided into a plurality of cells, and then the cells are combined.

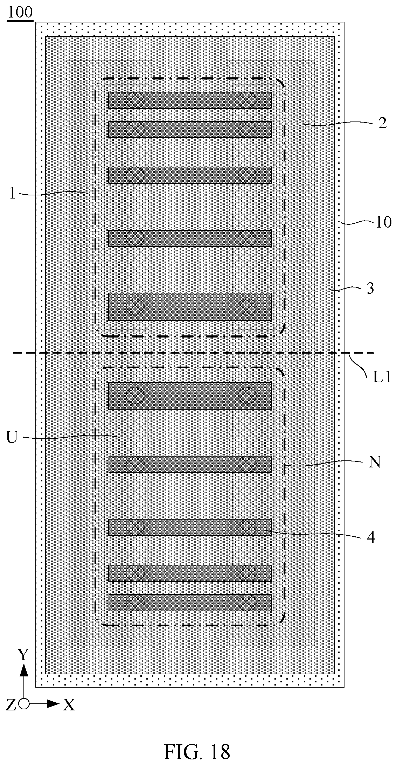

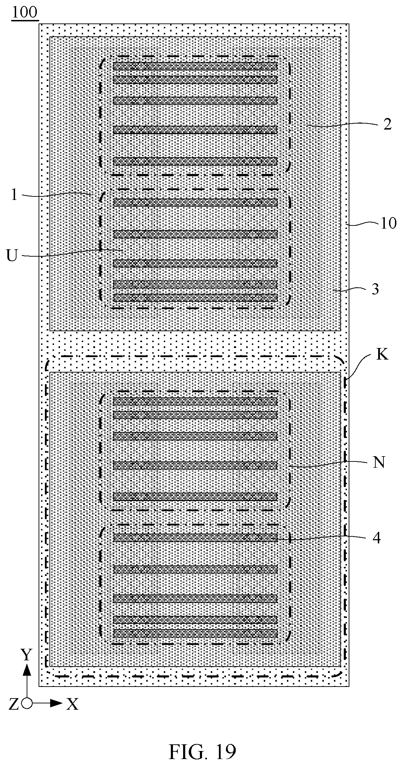

In some embodiments, refer to FIG. 18. In the radio frequency power assembly 100, each pair of connected chips (for example, the first chip 1 and the second chip 2) may include a plurality of cells N, and each cell N includes a plurality of (at least three) conductive blocks 4 that are spaced and arranged in the second direction Y. Refer to FIG. 19. The plurality of cells N may be arranged in the second direction Y.

For example, refer to FIG. 18. The first chip 1 may include a plurality of pads U that are disposed in isolation from each other (where in the figure, an example in which one chip includes two pads U is used), and at least one pad U may be correspondingly disposed in each cell N. It may be understood that the same applies to a pad U in the second chip 2.

For a radio frequency power assembly with a higher power level, multi-chip combination may be performed based on the diagram in FIG. 18, to further improve a power of the radio frequency power assembly.

For example, refer to FIG. 18. The plurality of conductive blocks 4 in the plurality of cells N corresponding to each pair of connected chips may be symmetrically arranged about a first reference line L1 serving as an axis of symmetry. The first reference line L1 is a center line between the two cells N, and the first reference line L1 is parallel to the first direction X.

In some embodiments, refer to FIG. 19. The radio frequency power assembly 100 includes a plurality of unit modules K, and each unit module K includes the first chip 1, the second chip 2, the insulation layer 3, the conductive block 4, the first connection part 51, and the second connection part 52.

Refer to FIG. 19. The plurality of unit modules K may be arranged in the first direction X (not shown in the figure) and/or the second direction Y.

That is, devices in the radio frequency power assembly 100 provided in embodiments of this application may be added in the first direction X or the second direction Y, so that the radio frequency power assembly 100 can be flexibly used in a plurality of different application scenarios.

The foregoing descriptions are merely specific implementations of this application, but are not intended to limit the protection scope of this application. Any variation or replacement readily figured out by a person skilled in the art within the technical scope disclosed in the present disclosure shall fall within the protection scope of this application. Therefore, the protection scope of this application shall be subject to the protection scope of the claims.

## Claims

1. A radio frequency power assembly, comprising:
a substrate;
a first chip and a second chip, disposed on a same side of the substrate, wherein the first chip and the second chip are arranged in a first direction, and the first direction is parallel to the substrate;
an insulation layer, at least partially disposed on a side that is of the first chip and the second chip and that is away from the substrate;
at least three conductive blocks, disposed on a side that is of the insulation layer and that is away from the substrate, wherein the at least three conductive blocks are spaced and arranged in a second direction, and the second direction is parallel to the substrate and intersects with the first direction; and
a first connection part and a second connection part, wherein one end of the first connection part penetrates the insulation layer and is electrically connected to the first chip, and the other end is electrically connected to one end of a conductive block; and one end of the second connection part penetrates the insulation layer and is electrically connected to the second chip, and the other end is electrically connected to the other end of the conductive block, wherein
areas of surfaces that are of at least two of the three conductive blocks and that are away from the substrate are different.

2. The radio frequency power assembly according to claim 1, wherein the conductive block extends from the first connection part to the second connection part, and a width of the conductive block is a size of the conductive block in a direction perpendicular to an extension path and parallel to the substrate, wherein
widths of at least two of the three conductive blocks are different.

3. The radio frequency power assembly according to claim 1 or 2, wherein the conductive block extends from the first connection part to the second connection part, and a length of the conductive block is a maximum size of the conductive block in the extension path, wherein
lengths of at least two of the three conductive blocks are different.

4. The radio frequency power assembly according to any one of claims 1 to 3, wherein the conductive block comprises a first sub-part and a second sub-part that are sequentially connected in the first direction, widths and/or lengths of a plurality of first sub-parts corresponding to the at least three conductive blocks are the same, and widths and/or lengths of second sub-parts corresponding to at least two of the three conductive blocks are different.

5. The radio frequency power assembly according to any one of claims 1 to 4, wherein thicknesses of at least two of the three conductive blocks are different; the thickness of the conductive block is a size of the conductive block in a third direction; and the third direction is perpendicular to a surface that is of the insulation layer and that is away from the substrate.

6. The radio frequency power assembly according to any one of claims 1 to 5, wherein in the at least three conductive blocks, a spacing between at least one pair of adjacently arranged conductive blocks is different from a spacing between another pair of adjacently arranged conductive blocks.

7. The radio frequency power assembly according to any one of claims 1 to 6, wherein the at least three conductive blocks are symmetrically arranged about a reference line serving as an axis of symmetry, and the reference line is parallel to the substrate and parallel to the first direction.

8. The radio frequency power assembly according to any one of claims 1 to 7, wherein the first chip and the first connection part are integrally disposed, and the second chip and the second connection part are integrally disposed; or
the conductive block, the first connection part, and the second connection part are integrally disposed.

9. The radio frequency power assembly according to any one of claims 1 to 8, further comprising:
at least one electronic element, disposed on the side that is of the insulation layer and that is away from the substrate, wherein
the conductive block is electrically connected to the first connection part through the electronic element, and/or the conductive block is electrically connected to the second connection part through the electronic element.

10. The radio frequency power assembly according to any one of claims 1 to 9, wherein the radio frequency power assembly comprises a plurality of second chips, and the plurality of second chips are respectively disposed on different sides of the first chip.

11. The radio frequency power assembly according to any one of claims 1 to 10, wherein the radio frequency power assembly comprises:
a plurality of unit modules, wherein each unit module comprises the first chip, the second chip, the insulation layer, the conductive block, the first connection part, and the second connection part, wherein
the plurality of unit modules are arranged in the first direction and/or the second direction.

12. A radio frequency power assembly, comprising:
a substrate;
a first chip and a second chip, disposed on a same side of the substrate, wherein the first chip and the second chip are arranged in a first direction, and the first direction is parallel to the substrate;
an insulation layer, at least partially disposed on a side that is of the first chip and the second chip and that is away from the substrate;
at least three conductive blocks, disposed on a side that is of the insulation layer and that is away from the substrate, wherein the at least three conductive blocks are spaced and arranged in a second direction, and the second direction is parallel to the substrate and intersects with the first direction; and
a first connection part and a second connection part, wherein one end of the first connection part penetrates the insulation layer and is electrically connected to the first chip, and the other end is electrically connected to one end of a conductive block; and one end of the second connection part penetrates the insulation layer and is electrically connected to the second chip, and the other end is electrically connected to the other end of the conductive block, wherein
in the at least three conductive blocks, a spacing between at least one pair of adjacently arranged conductive blocks is different from a spacing between another pair of adjacently arranged conductive blocks.

13. An electronic device, comprising:
the radio frequency power assembly according to any one of claims 1 to 12; and
an antenna, coupled to the radio frequency power assembly.
